# EUROPEAN PATENT APPLICATION

(11) **EP 4 322 347 A1**
(43) Date of publication of application: **14.02.2024**
(21) Application number: 23189289.4
(22) Date of filing: 02.08.2023
(51) Int. Cl.: H01S 5/30, H01S 5/02, H01S 5/183

(54) **LAYERED STRUCTURE**

(30) Priority: 11.08.2022 GB 202211774
(71) Applicant: IQE plc, Cardiff CF3 0LW (GB)
(72) Inventor: Johnson, Andrew, Cardiff, CF3 0LW (GB)
(74) Representative: Jones, Luke François

(57) **Abstract**

The present disclosure relates to a layered structure (200, 300) comprising: a substrate (110) comprising a p-type semiconductor material; a plurality of semiconductor layers (120), on the substrate (110), comprising at least one p-on-n junction; and a tunnel junction layer (130) between the substrate (110) and the plurality of semiconductor layers.

## Description

### Technical field

The present application relates to a layered structure and a method of fabricating a layered structure.

### Background

A layered semiconductor structure is typically formed of multiple layers which are epitaxially grown in a stack. The layered structure may be grown using a number of methods, such as chemical vapour deposition (CVD), metal organic CVD (MOCVD), metalorganic vapour-phase epitaxy (MOVPE) and molecular beam epitaxy (MBE). Typically, multiple layers are grown layer-by-layer on a substrate. The substrate, and the layers, typically comprise semiconductor material. However, other materials may also be incorporated into the layered structure.

The layers are grown on the substrate to form a layered structure, which may be referred to as a wafer. The wafer may subsequently be fabricated into an electronic or photonic device, such as a transistor, a light emitting diode (LED) a vertical cavity surface emitting laser (VCSEL), an edge emitting laser and a photodetector.

The specific material chosen for the substrate, and for each of the layers of the wafer, can dictate the properties of the device, which is subsequently fabricated from the wafer. Increasingly, III-V semiconductor materials are being used in wafers for device fabrication, due to some of the desirable qualities that III-V materials present. Typically, a III-V semiconductor material is grown in layers on a III-V semiconductor substrate.

### Summary

Additionally, growing III-V semiconductor layers on a group IV semiconductor substrate has also been explored. This layered structure combination can take advantage of some of the desirable properties that III-V semiconductor materials present, whilst also utilising the well-developed complementary metal-oxide-semiconductor (CMOS) fabrication techniques that have been developed with group IV semiconductor materials, such as Si and Ge.

The combination of the III-V semiconductor materials on the group IV semiconductor substrate can be dictated by the lattice constants of the materials used. For example, III-V semiconductor materials, such as GaAs and AlAs, have a relatively similar lattice constant to the group IV semiconductor material Ge. Growing GaAs and AlAs layers on a Ge substrate can therefore lead to an epitaxially grown layered structure which can exhibit desirable low strain properties. However, it will be appreciated that this is one example combination of suitable III-V semiconductor materials and group IV semiconductor substrate, and one skilled in the art will understand that other material combinations may be used to form a layered structure.

Many devices fabricated from a layered structure, such as an epitaxially grown wafer, comprise a p-on-n junction structure. For example, a VCSEL typically comprises a n-type reflector, a p-type reflector on the n-type reflector and an active layer situated between the n-type reflector and the p-type reflector. The configuration of the n-type reflector and the p-type reflector forms a p-on-n junction.

A layered structure for forming devices comprising a p-on-n junction may thus comprise a plurality of semiconductor layers comprising a p-on-n junction. In such layered structures, it is common to dope the substrate n-type. The n-type substrate can act as a low-resistance material relative to the n-type section of the p-on-n junction, which is situated on the substrate. A contact may thus be formed on the n-type substrate to apply a current to the device, which is low resistance and may be ohmic in nature. The formation of an ohmic contact on the n-type substrate may thus lead to a device with low resistance and low losses.

In some materials, however, ohmic contacting of substrates can be challenging. In some materials, a fermi level pinning effect can occur in the substrate material, which means that ohmic contacts cannot be easily formed on the substrate. The use of such substrate materials can increase resistances in the device and can lead to increased losses. Additionally, the use of such substrates, may involve an intensive and restrictive solution to fabricate a suitable contact on the substrate. The fermi level pinning effect has been observed for n-type Ge substrates. This effect thus limits the use of substrates, such as n-type Ge substrates, for growing a device using III-V semiconductors materials.

It is an object of the disclosure to obviate or eliminate at least some of the above-described disadvantages associated with existing techniques.

According to a first aspect there is provided a layered structure comprising: a substrate comprising a p-type semiconductor material; a plurality of semiconductor layers, on the substrate, comprising at least one p-on-n junction; and a tunnel junction layer between the substrate and the plurality of semiconductor layers.

In some examples, a p-type substrate material may not suffer from the fermi level pinning effect, which the equivalent n-type substrate material may suffer from. It has been observed that p-type Ge does not suffer from a fermi level pinning effect, which n-type Ge suffers from. Thus, in some examples, a p-type equivalent material can more readily form an ohmic contact. As such, the p-type semiconductor material can result in an ohmic contact being fabricated on the substrate. However, as described above, some layered structures comprise a p-on-n junction, such as in a layered structure for forming a VCSEL. In such layered structures, the n-type layer of the p-on-n junction can form a non-p junction with the p-type substrate. This n-on-p junction may thus be in the opposite orientation to the p-on-n junction of the semiconductor layers of the layered structure. The n-on-p junction between the p-type substrate and the n-type layer(s) of the p-on-n junction may thus form a voltage barrier inhibiting the conduction of a device fabricated from the layered structure. In some examples, the n-on-p junction between the p-type substrate and the n-type semiconductor layer(s) may even form a rectifying diode further inhibiting conduction.

According to examples of the present disclosure, a tunnel junction layer is thus included in the layered structure, between the substrate and the plurality of semiconductor layers. The tunnel junction layer can enable charge carriers to tunnel across the barrier, which may be present between the p-type substrate and the n-type layer(s) of the p-on-n junction. As such, the tunnel junction layer can result in a device, with low losses and can enable ohmic contacting to a substrate.

In some examples, the tunnel junction layer may comprise a n-on-p tunnel junction. Advantageously, the n-on-p tunnel junction enables charge carriers to tunnel across the barrier which may be present between the p-type substrate and the n-type layer of the p-on-n junction thereby leading to a device with low resistance and low losses.

In some examples, a n-type semiconductor tunnel layer of the n-on-p tunnel junction may comprise a diffusion layer formed by diffusion from the plurality of semiconductor layers to the tunnel junction layer. In some examples, the n-on-p tunnel junction may be formed by growing a p-type semiconductor layer on the substrate and the plurality of semiconductor layers on the p-type semiconductor layer. In such examples, due to the doping of the p-type semiconductor layer, n-type atoms may diffuse from the semiconductor layers towards the p-type layer, thereby forming the n-type layer of the non-p tunnel junction. Advantageously, this leads to a fabrication method with reduced processing steps, which in turn may reduce processing time.

In some examples, the p-type semiconductor material of the substrate may comprise Ge. Advantageously, p-type Ge can form an ohmic contact with a contact material and can be used as a platform for growing layers of III-V semiconductor material with low strain properties.

In some examples, the tunnel junction layer may comprise Ge. Advantageously, a tunnel junction layer comprising Ge may have a desirable lattice constant, relative to the substrate and the plurality of semiconductor layers, which can be used to form a layered structure with low strain properties.

In some examples, the tunnel junction layer may comprise a first material and wherein the substrate may comprise the first material. Advantageously, the tunnel junction layer comprising the same material as the substrate may thus be readily grown on the substrate with low strain leading to a layered structure with desirable low strain properties.

In some examples, the tunnel junction layer may be adjacent to the substrate. Advantageously, growing the tunnel junction layer directly on the substrate may lead to a layered structure with desirable low strain properties.

In some examples, the layered structure may further comprise one or more buffer layers between the substrate and the tunnel junction layer. Advantageously, the one or more buffer layers may mitigate the effect of surface contaminants on the substrate and smooth the morphology of the substrate further leading to a layered structure with desirable low strain properties.

In some examples, the at least one p-on-n junction may comprise a n-type semiconductor layer, a p-type semiconductor layer and one or more intermediary semiconductor layers between the n-type semiconductor layer and the p-type semiconductor layer. Advantageously, the one or more intermediary semiconductor layers may enable a device to perform a given function.

In some examples, the one or more intermediary semiconductor layers may comprise an active layer for emitting or absorbing light. Advantageously, the layered structure may thus be used for forming a device for emitting or absorbing light.

In some examples, the n-type semiconductor layer may be adjacent the tunnel junction layer. Advantageously, the tunnel junction layer may enable charge carriers to tunnel across the barrier between the p-type substrate and the n-type semiconductor layer of the p-on-n junction.

In some examples, the at least one p-on-n junction may comprise a n-type reflector and a p-type reflector. Advantageously, the n-type reflector and the p-type reflector be used for forming a device with low resistance and low losses.

In some examples, the plurality of semiconductor layers may comprise III-V semiconductor material. Advantageously, the layered structure may thus be used to form a device utilising the desirable properties of III-V semiconductor materials.

In some examples, the layered structure may form one of: a light emitting diode (LED); a vertical cavity surface emitting laser (VCSEL); an edge emitting laser; and a photodetector. Advantageously, the LED, VCSEL, edge emitting laser or the photodetector may comprise a device with low resistance and low losses.

According to another aspect of the present disclosure, there is provided a method of fabricating a layered structure comprising: forming a tunnel junction layer on a substrate, wherein the substrate comprises a p-type semiconductor material; and growing, on the tunnel junction layer, a plurality of semiconductor layers; wherein growing the plurality of semiconductor layers comprises growing at least one p-on-n junction. Advantageously, the layered structure can result in a device with low losses and can enable ohmic contacting to a substrate.

In some examples, growing the tunnel junction layer may comprise forming a n-on-p tunnel junction. Advantageously, the n-on-p tunnel junction enables charge carriers to tunnel across the barrier which may be present between the p-type substrate and the n-type layer of the p-on-n junction, thereby leading to a device with low resistance and low losses.

In some examples, forming the tunnel junction layer may comprise growing the tunnel junction layer and forming the n-on-p tunnel junction may comprise growing a p-type semiconductor layer on the substrate and growing a n-type semiconductor on the p-type semiconductor layer. Advantageously, growing the p-type semiconductor layer and the n-type semiconductor layer may lead to a uniform n-on-p tunnel junction with controlled thickness and resistance properties.

In some examples, forming the n-on-p tunnel junction may comprise growing a p-type semiconductor tunnel layer on the substrate and forming a n-type semiconductor tunnel layer on the p-type semiconductor tunnel layer may comprise diffusing n-type material from the plurality of semiconductor layers to the tunnel junction layer. In such examples, due to the high doping of the p-type semiconductor layer, n-type atoms may diffuse from the semiconductor layers towards the p-type layer, thereby forming the n-type layer of the n-on-p tunnel junction. Advantageously, this leads to a fabrication method with reduced processing steps, which in turn may reduce processing time.

In some examples, the p-type semiconductor material may comprise Ge. Advantageously, p-type Ge can form an ohmic contact with a contact material and can be used as a platform for growing layers of III-V semiconductor material with low strain properties.

In some examples, the tunnel junction layer may comprise Ge. Advantageously, a tunnel junction layer comprising Ge may have a desirable lattice constant, relative to the substrate and the plurality of semiconductor layers, which can be used to form a layered structure with low strain properties.

In some examples, the tunnel junction layer may comprise a first material and wherein the substrate may comprise the first material. Advantageously, the tunnel junction layer, comprising the same material as the substrate, may be readily grown on the substrate with low strain leading to a layered structure with desirable low strain properties.

In some examples, the tunnel junction layer may be adjacent the substrate. Advantageously, growing the tunnel junction layer directly on the substrate may lead to a layered structure with desirable low strain properties.

In some examples, growing the at least one p-on-n junction may comprise: growing a n-type semiconductor layer; growing one or more intermediary semiconductor layers on the n-type semiconductor layer; and growing a p-type semiconductor layer on the one or more intermediary semiconductor layers. In some examples, growing the n-type semiconductor layer, growing the one or more intermediary semiconductor layers and growing the p-type semiconductor layer, comprises growth by epitaxy. Advantageously, the one or more intermediary semiconductor layers may enable a device to perform a given function.

In some examples, growing the at least one p-on-n junction may comprise growing a n-type reflector and growing a p-type reflector. Advantageously, the n-type reflector and the p-type reflector be used for forming a device with low resistance and low losses.

According to another aspect of the present disclosure, there is provided a layered structure comprising: a substrate comprising p-type semiconductor material; one or more semiconductor layers for forming a device; and a tunnel junction layer between the substrate and the one or more semiconductor layers. Advantageously, the layered structure can result in a device with low losses and can enable ohmic contacting to a substrate.

### Brief description of the drawings

For a better understanding of the techniques, and to show how it may be put into effect, reference will now be made, by way of example, to the accompanying drawings, in which:
Figure 1 is a schematic cross-section of a layered structure;
Figure 2 is a schematic cross-section of a layered structure;
Figure 3 is a schematic cross-section of a layered structure;
Figure 4 is a flowchart illustrating a method for fabricating a layered structure.

### Detailed Description

Epitaxy or epitaxial means crystalline growth of material, usually via high temperature deposition. Epitaxy can be affected in a molecular beam epitaxy (MBE) tool in which layers are grown on a heated substrate in an ultra-high vacuum environment. Elemental sources are heated in a furnace and directed towards the substrate without carrier gases. The elemental constituents react at the substrate surface to create a deposited layer. Each layer is allowed to reach its lowest energy state before the next layer is grown so that bonds are formed between the layers. Epitaxy can also be performed in a metal-organic vapour phase epitaxy (MOVPE) tool, also known as a metal-organic chemical vapour deposition (MOCVD) tool. Compound metal-organic and hydride sources are flowed over a heated surface using a carrier gas, typically hydrogen. Epitaxial deposition occurs at much higher pressure than in an MBE tool. The compound constituents are cracked in the gas phase a then reacted at the surface to grow layers of desired composition. Layered structures according to examples of the present may be grown by epitaxy.

Deposition means the depositing of a layer on another layer or substrate. It encompasses epitaxy, chemical vapour deposition (CVD), powder bed deposition and other known techniques to deposit material in a layer.

A compound material comprising one or more materials from group III of the periodic table with one or more materials from group V is known as a III-V material. The compounds have a 1:1 combination of group III and group V regardless of the number of elements from each group. Subscripts in chemical symbols of compounds refer to the proportion of that element within that group. Thus Al_{0.25}GaAs means the group III part comprises 25% Al, and thus 75% Ga, whilst the group V part comprises 100% As.

Crystalline means a material or layer with a single crystal orientation. In epitaxial growth or deposition subsequent layers with the same or similar lattice constant follow the registry of the previous crystalline layer and therefore grow with the same crystal orientation. In-plane is used herein to mean parallel to the surface of the substrate; out-of-plane is used to mean perpendicular to the surface of the substrate.

Throughout this disclosure, as will be understood by the skilled reader, crystal orientation <100> means the face of a cubic crystal structure and encompasses [100], [010] and [001] orientations using the Miller indices. Similarly <001> encompasses [001] and [00-1] except if the material polarity is critical. Integer multiples of any one or more of the indices are equivalent to the unitary version of the index. For example, (222) is equivalent to, the same as, (111).

Substrate means a planar wafer on which subsequent layers may be deposited or grown. A substrate may be formed of a single element or a compound material, and may be doped or undoped. For example, substrates can include silicon (Si), Germanium (Ge), gallium arsenide (GaAs), silicon germanium (SiGe), silicon germanium tin (SiGeSn), indium phosphide (InP), and gallium antimonide (GaSb).

A substrate may be on-axis, that is where the growth surface aligns with a crystal plane. For example it has <100> crystal orientation. References herein to a substrate in a given orientation also encompass a substrate which is miscut by up to 20° towards another crystallographic direction, for example a (100) substrate miscut towards the (111) plane. Vertical or out of plane means in the growth direction; lateral or in-plane means parallel to the substrate surface and perpendicular to the growth direction.

Doping means that a layer or material contains a small impurity concentration of another element (dopant) which donates (donor) or extracts (acceptor) charge carriers from the parent material and therefore alters the conductivity. Charge carriers may be electrons or holes. A doped material with extra electrons is called n-type whilst a doped material with extra holes (fewer electrons) is called p-type.

Lattice matched means that two crystalline layers have the same, or similar, lattice spacing and so the second layer will tend to grow isomorphically on the first layer. Lattice constant is the unstrained lattice spacing of the crystalline unit cell. Lattice coincident means that a crystalline layer has a lattice constant which is, or is close to, an integer multiple of the previous layer so that the atoms can be in registry with the previous layer. Lattice mismatch is where the lattice constants of two adjacent layers are neither lattice matched nor lattice coincident. Such mismatch introduces elastic strain into the structure, particularly the second layer, as the second layer adopts the in-plane lattice spacing of the first layer. The strain is compressive where the second layer has a larger lattice constant and tensile where the second layer has a smaller lattice constant.

Where the strain is too great the structure relaxes to minimise energy through defect generation, typically dislocations, known as slip, or additional interstitial bonds, each of which allows the layer to revert towards its lattice constant. The strain may be too great due to a large lattice mismatch or due to an accumulation of small mismatches over many layers. A relaxed layer is known as metamorphic, incoherent, incommensurate or relaxed, which terms are also commonly interchangeable.

Where a device is described it should be understood that it will typically be formed on a circular substrate wafer of 4" (100mm), 6" (150mm), 8" (200mm), 12" (300mm) or greater diameter. After growth, deposition, bonding and other fabrication steps the devices are separated by dicing the wafer and layers into devices (chips) of appropriate dimensions. Typically tens, hundreds or thousands of devices are cut from a single wafer.

In this description "top" means the upper surface of a layer or the layered structure and generally refers to the surface which has suitable surface finish for further deposition, for example of intermediate or semiconductor layers for forming a device. "Bottom" means the lower surface of a layer or the layered structure and refers to the surface which abuts a previous layer or the substrate, or the back side of the substrate. In general, epitaxial deposition occurs with the substrate placed into a suitable machine and layers added in sequence to the top surface of the substrate. Thus, the top of the substrate is adjacent to the bottom of the first layer; the top of the first layer is adjacent to the bottom of the second layer; and so on.

In this description "layer" means a planar section of a layered structure which has a top surface and a bottom surface, and is of uniform thickness in the growth direction. Its lateral extent will generally match that of layers above and below it. A layer may also comprise discrete sections with gaps between the sections, formed using a mask or by subsequent selective etching, which nonetheless occupies a defined part of the vertical extent of the layered structure and is deposited in a single operation. A layer may have uniform material properties throughout or may have graded or stepped material properties which change through the thickness of the layer, that is in the growth direction from bottom to top.

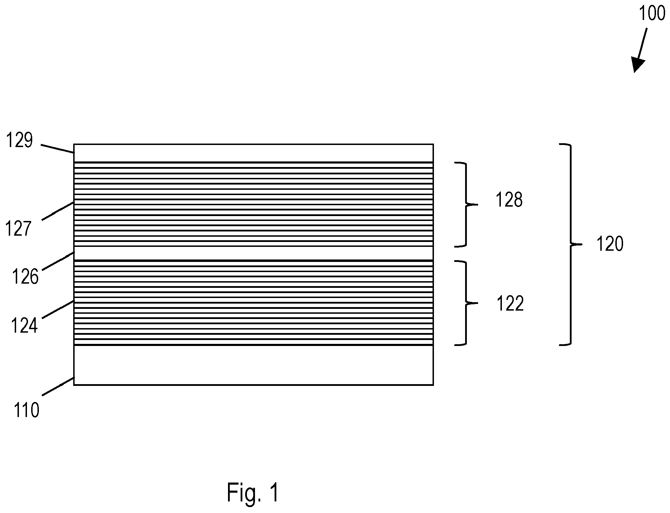

**Figure 1** illustrates a known layered structure 100 comprising a substrate 110 and a plurality of semiconductor layers 120 on the substrate 110. In some examples, the layered structure 100 may be used for forming a device. In the illustrated example of Figure 1, the layered structure 100 may be used for form a VCSEL.

Plurality of semiconductor layers 120 may thus comprise a lower reflector 122 formed from a plurality of lower reflector layers 124. The lower reflector 122 may be grown over the substrate 110. The lower reflector layers 124 may comprise alternating layers of two materials forming reflector pairs. The lower reflector 122 may be a distributed Bragg reflector (DBR). In one example, the mirror pairs of lower reflector 122 may comprise III-V semiconductor materials, such as, GaAs and AlAs.

Plurality of semiconductor layers 120 further comprises an active layer 126 grown over the lower reflector 122. The active layer 126 may be bulk material, such as a dilute nitride material including up to 5% nitrogen atom concentration. The active layer 126 may comprise semiconductor material such as AllnGaP. Alternatively, the active layer 126 may comprise quantum wells or quantum dots. The active layer 126 generates and emits photons by the recombination of electrons and holes which are injected into the VCSEL. The material and format, i.e. bulk, quantum wells or quantum dots, may be chosen to yield the desired output wavelength, power or high temperature performance. In some examples, the desired output wavelength may be between about 800 nm and about 1600 nm.

In other examples, a layered structure may be formed comprising an active layer for absorbing light. In such examples, the desired absorption wavelength may be between about 800 nm and about 1700 nm.

The active layer 126 may further include an oxidation sublayer which is oxidised to provide an aperture to channel the charge carriers and for the emission of light. The oxidation sublayer may have a high aluminium content so that the sublayer is oxidised at a faster rate than other layers.

Plurality of semiconductor layers 120 further comprises an upper reflector 128 grown over the active layer 126. The upper reflector 128 comprises alternating layers of material in mirror pairs, in a similar manner to the lower reflector 122. The mirror pairs of the upper reflector 128 may comprise III-V semiconductor materials, such as, GaAs and AlAs, in a similar manner to the lower reflector 122. Upper reflector 128 may thus also comprise a DBR.

In one example, upper reflector 128 may comprise 20 reflector pairs and lower reflector 122 may comprise 30 reflector pairs. In this way, upper reflector 128 may be more transparent than lower reflector 122. Upper reflector 128 may further allow at least some light to pass through the upper reflector 128. In this way, the plurality of semiconductor layers 120 may form a top-emitting VCSEL. Plurality of semiconductor layers 120 may thus further comprise a capping layer 129 over the upper reflector 128. The capping layer 129 may be transparent to the emitted light so as not to obstruct light emission.

Although not illustrated in Figure 1, contacts may be formed on layered structure 100 to apply an electrical current to a device formed from the layered structure 100. In some examples, one contact may be formed on substrate 110 and another contact may be formed on the capping layer 129.

Lower reflector 122 may be doped n-type and upper reflector 128 may be doped p-type. Such a doping orientation is common for a top-emitting VCSEL. In some examples, where the lower reflector 122 is primarily formed of III-V semiconductor materials, such as GaAs and AlAs, the lower reflector 122 may be doped n-type be the addition of one or more of: Si, Te, Sand Se. In some examples, where the upper reflector 128 is primarily formed of III-V semiconductor materials, such as GaAs and AlAs, the upper reflector 128 may be doped p-type by the addition of C, Zn, Mg and Be.

Due to the doping of the lower reflector 122 and the upper reflector 128, the two reflectors thus form a p-on-n junction, with the active layer 126 between the lower reflector 122 and the upper reflector 128. As described above, many layered structures may comprise a p-on-n junction structure for device fabrication. Due to the p-on-n junction structure, substrate 110 may thus be doped n-type, to act as a low-resistance contact material coupled to the n-type lower reflector 122.

As further described above, there is interest in using a group IV semiconductor material in the substrate 110 for growing layers of III-V semiconductor materials in a layered structure. In one example, substrate 110 may comprise Ge. The lattice constant of Ge (5.658Å at 300K), GaAs (lattice constant 5.6533Å at 300K) and AlAs (lattice constant 5.6611Å at 300K), is relatively close. As such, there is interest in growing GaAs and AlAs layers on a Ge substrate as this can lead to layered structures with desirable low strain properties.

Due to the p-on-n structure of many layered structures, typically, the substrate 110 is doped n-type. A group IV semiconductor substrate, such as Ge, can be doped n-type by the addition of group V materials, such as P, As and Sb. However, as described above, ohmic contacting some substrate materials, such as n-type Ge, can be challenging due to the fermi level pinning effect that can occur in these materials. Using substrates, such as n-type Ge, for growing III-V semiconductor layers can thus lead to a device with relatively high resistance and increased losses and which may involve an intensive and restrictive solution to fabricate a suitable contact on the substrate.

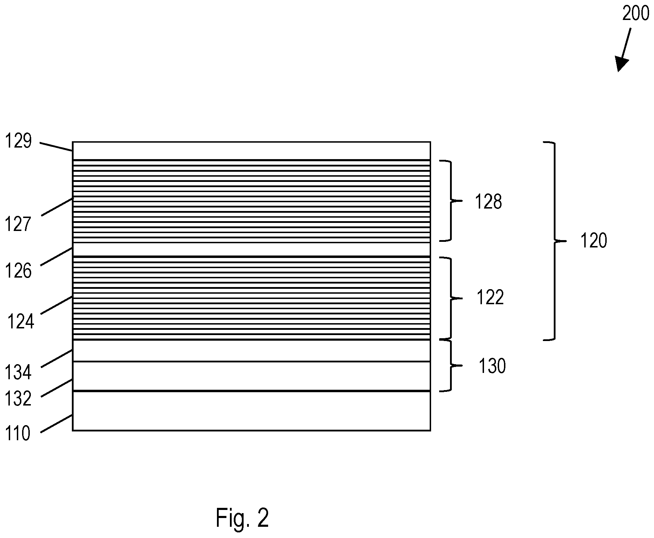

**Figure 2** illustrates a layered structure 200 according to examples of the present disclosure. Layered structure 200 comprises elements in common with layered structure 100 described above with respect to Figure 1. Such elements are labelled with corresponding reference numerals and may operate in a substantially corresponding way to that described above.

Layered structure 200 comprises a substrate 110, which is doped p-type. Some p-type substrates may not suffer from the fermi level pinning effect, which can be present in their n-type equivalent. One such example is a p-type Ge substrate. A contact may thus be fabricated on to a p-type Ge substrate which is low resistance and ohmic in nature. A group IV semiconductor substrate, such as Ge, can be doped p-type by the addition of group III materials, such as Al, Ga and In.

Layered structure 200 further comprises a tunnel junction layer 130. Tunnel junction layer 130 comprises p-type layer 132 and n-type layer 134 on the p-type layer 132. Tunnel junction layer 130 thus comprises a n-on-p tunnel junction by the formation of p-type layer 132 and n-type layer 134. In some examples, p-type layer 132 and n-type layer 134 may be heavily doped p++ and n++, respectively.

As described above, a n-on-p junction may be formed between a p-type substrate 110 and the n-layer of a p-on-n junction comprised in the plurality of semiconductor layers 120. Such a n-on-p junction can occur between substrate 110 and lower reflector 122 of layered structure 100 illustrated in Figure 1. Such a p-on-n junction can increase resistance and losses, as described above.

Layered structure 200 thus comprises tunnel junction layer 130 between the substrate 110 and the plurality of semiconductor layers 120. Tunnel junction 130 may thus enable charge carriers to tunnel across the barrier between the p-type substrate 110 and n-type lower reflector 122 of the plurality of semiconductor layers 120, thereby reducing resistance and losses.

In some examples, tunnel junction layer 130 may be formed by epitaxially growing the p-type layer 132 on substrate 110 and epitaxially growing the n-type layer on the p-type layer 132. In this way, a relatively thin tunnel junction may be formed with a thickness of about 10 nm.

In some examples, tunnel junction layer 130 may be formed by epitaxially growing a p-type layer 132 on substrate 110. The plurality of semiconductor layers 120 may subsequently be grown on the p-type layer 134. In some examples, due to the high p++ doping of p-type layer 132, this may cause n-type atoms to diffuse from the semiconductor layers of the plurality of semiconductor layers 120 to the region adjacent p-type layer 132. The diffusion of the n-type atoms to the region adjacent p-type layer 132 may thus effectively form n-type layer 134 adjacent p-type layer 132 and thereby form tunnel junction layer 130. In such examples, n-type layer 134 may comprise a diffusion layer formed by diffusion from the semiconductor layers of plurality of semiconductor layers 120. In such examples, where n-type layer 134 is formed by diffusion, tunnel junction may be relatively thick and may comprise a thickness of about 0.3 µm.

In some examples, the tunnel junction layer 130 may be formed of the same material as the substrate 110. For example, the substrate 110 may comprise Ge and the p-type layer 132 and the n-type layer 134 of the tunnel junction layer 130 may each comprise Ge.

As illustrated in Figure 2, tunnel junction layer 130 is adjacent the substrate 110. However, in other examples, one or more buffer layers may be present between the substrate 110 and the tunnel junction layer 130. In some examples, the one or more buffer layers may mitigate the effect of surface contaminants on the substrate 110 and smooth the morphology of the substrate 110, thereby leading to a layered structure 200 with desirable low strain properties.

As illustrated in Figure 2, the lower n-type reflector 122 is adjacent the tunnel junction layer 130. Thus, in some examples, the n-type layer of the p-on-n junction of the plurality of semiconductor layers 120 may be adjacent the tunnel junction layer 130. In other examples, one or more buffer layers may be present between the lower n-type reflector 122 and the tunnel junction layer 130. Thus, in some examples, one or more buffer layers may be present between the n-type layer of the p-on-n junction of the plurality of semiconductor layers 120 and the tunnel junction layer 130.

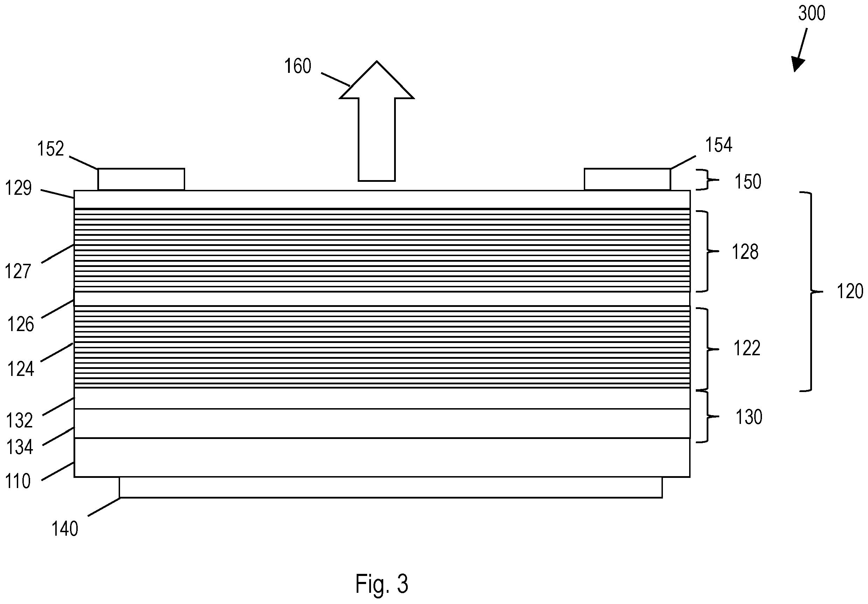

**Figure 3** illustrates a layered structure 300 according to examples of the present disclosure. Layered structure 300 comprises elements in common with layered structures 100, 200 described above with respect to Figure 1 and Figure 2. Such elements are labelled with corresponding reference numerals and may operate in a substantially corresponding way to that described above.

Layered structure 300 further comprises first contact layer 140 fabricated on substrate 110. Layered structure 300 further comprises second contact layer 150 fabricated on capping structure 129. Second contact layer 150 comprises first contact node 152 and second contact node 154.

As described above, plurality of semiconductor layers 120 may be used for forming a VCSEL. Application of an electrical current to the VCSEL via contact layers 140, 150 may thus result in recombination of electrons and holes in the active layer 126, which are injected into the VCSEL, leading to the emission of light 160 from a top side of the VCSEL. In some examples, the light may comprise a wavelength of between about 800 nm and about 1600 nm.

P-type substrate 110 may be formed of material that does not suffer from a fermi level pinning effect, such as p-type Ge. The first contact layer 140 may thus readily contact the p-type substrate 110 with an ohmic nature, without the use of an intensive or restrictive fabrication solution. The ohmic contacting to the p-type substrate 110 can thus reduce the resistance of the coupling between the substrate 110 and the first contact layer 140, leading to reduced resistance and reduced losses. Furthermore, the presence of tunnel junction layer 130 enables charge carriers to tunnel from the p-type substrate 110 to the semiconductor layers of the plurality of semiconductor layers 120. The tunnel junction 130 thus further reduces resistance and losses.

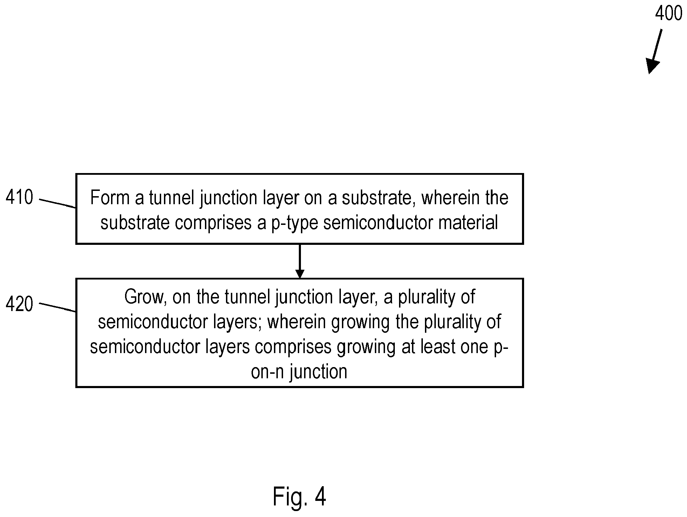

**Figure 4** is a flowchart illustrating processing steps in a method 400 for fabricating a layered structure according to examples of the present disclosure. Method 400 may thus be used to fabricate either of layered structures 200, 300, described above.

The method comprises, in a first step 410, forming a tunnel junction layer on a substrate wherein the substrate comprises a p-type semiconductor material. As described above, some p-type substrates may enable an ohmic contact to be fabricated on the substrate. In some examples, the p-type semiconductor material may comprise Ge.

The method further comprises, in a second step 420, growing a plurality of semiconductor layers; wherein growing the plurality of semiconductor layers comprises growing at least one p-on-n junction. In some examples, growing the plurality of semiconductor layers may comprise epitaxially growing the plurality of semiconductor layers.

In some examples, growing the tunnel junction layer may comprise forming a n-on-p tunnel junction. In some examples, forming the n-on-p tunnel junction may comprise growing the tunnel junction layer and forming the n-on-p tunnel junction comprises growing a p-type semiconductor layer on the substrate and growing a n-type semiconductor layer on the p-type semiconductor layer. In some examples, growing the tunnel junction layer may comprise epitaxially growing the tunnel junction layer. Epitaxially growing the n-on-p tunnel junction may allow a high level of control of the non-p tunnel junction leading to a n-on-p tunnel junction with well-defined properties. For example, the n-on-p tunnel junction may be relatively thin and may be about 10 nm.

In some examples, forming the n-on-p tunnel junction comprises growing a p-type semiconductor tunnel layer on the substrate and forming an n-type semiconductor tunnel layer on the p-type semiconductor layer comprising diffusing n-type material from the plurality of semiconductor layers to the tunnel junction layer. In such examples, formation of a layered structure may be quicker as the step of growing the n-type semiconductor on the tunnel junction may not be required, as the n-type layer may be formed by diffusion from the plurality of semiconductor layers. In such examples, however, the tunnel junction layer may be relatively thick and may be about 0.3 µm.

The disclosure above has substantially presented a layered structure according to examples of the present disclosure for formation of a VCSEL. The VCSEL may thus comprise at least one p-on-n junction, which comprises a n-type reflector, a p-type reflector and an active layer between the n-type reflector and the p-type reflector. However, in other examples, a layered structure according to examples of the present disclosure may form another device, where the layered structure comprises at least one p-on-n junction. Said devices may comprise one of: a LED, an edge emitting laser and a photodetector.

The p-on-n junction of such layered structures according to the present disclosure may thus comprise a n-type semiconductor layer and a p-type semiconductor layer. In some examples, the p-on-n junction may comprise one or more intermediary semiconductor layers, such as an active layer, between the n-type semiconductor layer and the p-type semiconductor layer.

It should be noted that the above-mentioned embodiments illustrate rather than limit the idea, and that those skilled in the art will be able to design many alternative embodiments without departing from the scope of the appended claims. The word "comprising" does not exclude the presence of elements or steps other than those listed in a claim, "a" or "an" does not exclude a plurality, and a single processor or other unit may fulfil the functions of several units recited in the claims. Any reference signs in the claims shall not be construed so as to limit their scope.

## Claims

1. A layered structure (200, 300) comprising:
a substrate (110) comprising a p-type semiconductor material;
a plurality of semiconductor layers (120), on the substrate (110), comprising at least one p-on-n junction; and
a tunnel junction layer (130) between the substrate (110) and the plurality of semiconductor layers (120).

2. A layered structure according to claim 1 wherein the tunnel junction layer (130) comprises a n-on-p tunnel junction.

3. A layered structure according to claim 2 wherein a n-type semiconductor tunnel layer of the n-on-p tunnel junction comprises a diffusion layer formed by diffusion from the plurality of semiconductor layers (120) to the tunnel junction layer (130).

4. A layered structure according to any preceding claim wherein the p-type semiconductor material of the substrate (110) comprises Ge.

5. A layered structure according to any preceding claim wherein the tunnel junction layer (130) comprises Ge.

6. A layered structure according to any preceding claim wherein the tunnel junction layer (130) comprises a first material and wherein the substrate (110) comprises the first material.

7. A layered structure according to any preceding claim further comprising one or more buffer layers between the substrate (110) and the tunnel junction layer (130).

8. A layered structure according to any preceding claim wherein the at least one p-on-n junction comprises a n-type reflector, a p-type reflector and an active layer (126) for emitting or absorbing light between the n-type reflector and the p-type reflector.

9. A layered structure according to claim 8 wherein the n-type reflector is adjacent the tunnel junction layer (130).

10. A layered structure according to any preceding claim wherein the plurality of semiconductor layers (120) comprise III-V semiconductor material.

11. Method of fabricating a layered structure (200, 300) comprising:
forming (410) a tunnel junction layer (130) on a substrate (110), wherein the substrate (110) comprises a p-type semiconductor material; and
growing (420), on the tunnel junction layer (130), a plurality of semiconductor layers (120); wherein growing the plurality of semiconductor layers (120) comprises growing at least one p-on-n junction.

12. A method according to claim 11 wherein growing the tunnel junction layer (130) comprises forming a n-on-p tunnel junction.

13. A method according to claim 12 wherein forming the tunnel junction layer (130) comprises growing the tunnel junction layer (130) and forming the n-on-p tunnel junction comprises growing a p-type semiconductor layer on the substrate (110) and growing a n-type semiconductor layer on the p-type semiconductor layer.

14. A method according to claim 12 wherein forming the n-on-p tunnel junction comprises growing a p-type semiconductor tunnel layer on the substrate (110) and forming a n-type semiconductor tunnel layer on the p-type semiconductor tunnel layer comprising diffusing n-type material from the plurality of semiconductor layers (120) to the tunnel junction layer (130).

15. A method according to any of claims 11-14 wherein growing the at least one p-on-n junction comprises:
growing a n-type reflector;
growing an active layer (126) for emitting or absorbing light on the n-type reflector; and
growing a p-type reflector on the active layer (126).
